# EUROPEAN PATENT SPECIFICATION

(11) **EP 2 661 019 B1**
(45) Date of publication and mention of the grant of the patent: **02.09.2020**
(21) Application number: 11852559.1
(22) Date of filing: 26.12.2011
(51) Int. Cl.: H04L 12/28, G06F 3/16

(54) **METHOD FOR OPERATING A PORTABLE TERMINAL**
VERFAHREN ZUM BETRIEB EINES TRAGBAREN ENDGERÄTS
PROCÉDÉ POUR FAIRE FONCTIONNER UN TERMINAL PORTABLE

(30) Priority: 31.12.2010 KR 20100140013; 24.11.2011 KR 20110123832
(43) Date of publication of application: 06.11.2013
(73) Proprietor: LG Electronics Inc., Yeongdeungpo-gu Seoul 150-721 (KR)
(72) Inventor: KIM, Hyun Sang, Changwon-si Kyungsangnam-do 641-110 (KR)
(74) Representative: Morrall, Jonathan Ian McLachlan
(86) International application number: PCT/KR2011/010098
(87) International publication number: WO 2012/091384

(56) References cited:
- EP-A2- 0 887 989
- WO-A1-2007/071812
- KR-A- 20100 112 950
- KR-A- 20100 122 029
- KR-A- 20100 122 030
- US-A1- 2002 130 784
- US-A1- 2005 028 034
- US-A1- 2008 036 619
- US-A1- 2008 122 648
- US-A1- 2010 292 960

## Description

### [Technical Field]

The present invention relates to a method of operating a portable terminal, which can diagnose a home appliance using the portable terminal.

### [Background Art]

Generally, when a failure occurs during the use of a home appliance, a user typically calls a service center to explain symptoms of the failures and to inquire about solutions. However, in case where a user recognizes the condition of a home appliance and explains it to a service center, the user cannot accurately grasp and explain unusual symptoms of the home appliance, and the service center also has difficulty in solving the troubles due to the user's poor explanation.

In particular, even when unusual symptoms of a home appliance do not come from failures of the home appliance but from a user's mal-operation or when such failures may be handled by a simple measurement of a user, the cause of the failure cannot be accurately diagnosed only by the user's explanation. Accordingly, the dissatisfaction of the user increases, and a service person is often unnecessarily dispatched, inhibiting efficient utilization of limited repair resources.

US2008/0122648 discloses an appliance network comprising an appliance in communication with an audio communication accessory to effect communication therebetween. WO 2007/071812 discloses a method and an apparatus for measuring and analyzing movements of a human or an animal using sound signals. US 2002/0130784 discloses a maintenance service system for home electric appliances which comprises a home electric appliance, a portable terminal which can communicate with said home electric appliance and an information providing server which can communicate with said portable terminal. US 2010/0292960 discloses a method of diagnosing an air conditioner and mobile terminal equipment for performing the method. The method of diagnosing the air conditioner using mobile terminal equipment includes beginning diagnosis of the air conditioner, displaying a diagnostic result of the air conditioner on a screen, and displaying a countermeasure for the diagnostic result. EP 0887989 A2 discloses a home appliance, such as a laundry washing machine or refrigerator including a buzzer designed to sound an alarm or provide an audible indication of a certain condition is disclosed. The appliance may transmit information (such as diagnostic or fault codes and appliance usage information) to a remote service centre without the need for a physical connection to a telephone line. The buzzer may be controlled to produce audible tones in a predetermined format which can be transmitted from the appliance, through the air and down a telephone line through a telephone handset to the service centre. The signal is recorded at the service centre and the data extracted. The data is then analysed to obtain the fault and/or usage information. US 20080036619 A1 discloses an appliance having a diagnostic capability including a tone generator, a controller, a data collection function, memory for storing the collected data, and a transmitter. The transmitter transmits a stream of data derived from the stored data using a carrier signal. The carrier signal is switched on and off according to bits in a stream of data derived from the stored data. The transmission also includes interleaving each bit for transmission with an off period of the carrier. Each off period of the carrier has a duration of at least 100 milliseconds. US 20050028034 discloses an acoustic channel used for fault diagnosis, repair, and upgrades. Remote diagnosis uses self-test data encoded into sound waves. Repair data and upgrades are also encoded and transmitted as sound waves.

### [Disclosure]

### [Technical Problem]

The present invention provides a method of operating a portable terminal, which can accurately diagnose unusual symptoms of a home appliance using the portable terminal.

The present invention also provides a method of operating a portable terminal, which can display results of diagnosis through a display unit.

The present invention provides a method of operating a portable terminal, which can more swiftly perform diagnosis on a home appliance.

### [Technical Solution]

The method of operating a portable terminal according to an embodiment of the present invention includes displaying a recording menu through a display unit; recording a signal sound received through a microphone according to a selection of the recording menu; extracting product information from the recorded signal sound; performing diagnosis based on extracted product information; and displaying a result of performing the diagnosis through the display unit.

### [Advantageous Effects]

In a method of operating a portable terminal according to an embodiment of the present invention, a user can directly diagnose a home appliance through a portable terminal without inquiring of a service center, thereby allowing unusual symptoms of the home appliance to be quickly grasped.

Also, in the method of operating the portable terminal according to the embodiment of the present invention, a user can take a proper measure by his/her own efforts based on diagnosis results of a home appliance, thereby allowing the home appliance to be more quickly and simply repaired and managed.

Furthermore, in the method of operating the portable terminal according to the embodiment of the present invention, a repairer can be prevented from unnecessarily often visiting a user.

### [Description of Drawings]

FIG. 1 is a view illustrating exemplary home appliance diagnosing systems.
FIG. 2 is a view illustrating main components of a portable terminal of FIG. 1.
FIG. 3 is a view illustrating a configuration of an application operating for diagnosis on a home appliance in the portable terminal of FIG. 2.
FIG. 4 is a flowchart illustrating a method of operating a portable terminal according to an embodiment of the present invention.
FIG. 5 is a flowchart illustrating a method of operating a portable terminal according to another embodiment of the present invention.
FIGS. 6 to 11 are views illustrating images displayed through a display unit of FIG. 2 during diagnosis of home appliances.

### [Best Mode]

Advantages and features of the present invention and methods of achieving the same will be apparent by referring to the embodiments described below in detail with reference to the accompanying drawings. However, the present invention is not limited to the embodiments described below and various modifications may be made thereto. The embodiments are merely provided to thoroughly disclose the invention and to convey the category of the invention to one of ordinary skill in the art. The present invention is defined by the appended claims. The same reference numerals denote the same elements throughout the specification.

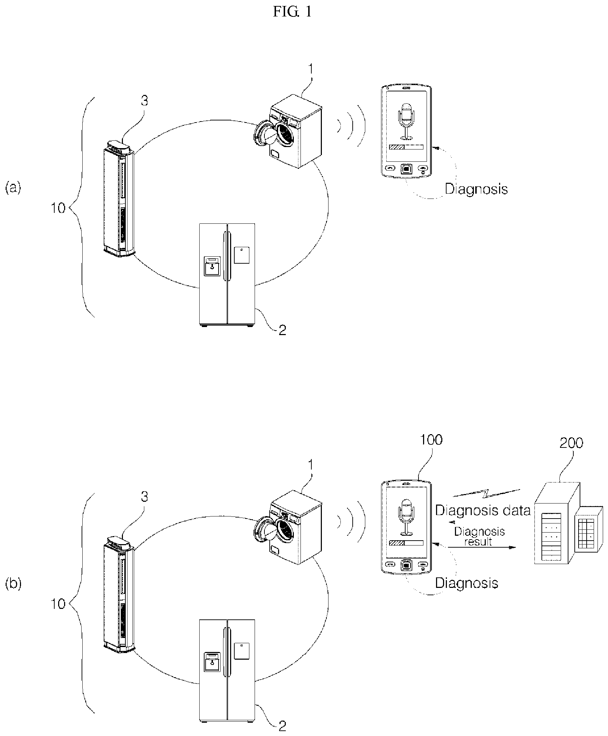

FIG. 1(a) shows an exemplary home appliance diagnosing system that performs diagnosis on a home appliance by a method of operating a home appliance according to an embodiment of the present invention.

Referring to FIG. 1(a), a home appliance diagnosing system 10 according to the embodiment includes a home appliance such as a laundry treating apparatus 1, a refrigerator 2, or an air conditioner 3, and a portable terminal 100 that receives a signal sound including product information output from the home appliance and diagnoses the state or failures of the home appliance based on the signal sound.

Examples of the portable terminal 100 may include a mobile phone, a smart phone, a laptop computer, a PDA (Personal Digital Assistant), a tablet computer, and an e-book reader. In particular, smart phones having functions of both mobile phones and PDAs gain more popularity. Compared with conventional mobile phones, smart phones have high-capacity memories and high-performance CPUs mounted therein, together with an operating system (OS) for supporting execution of various applications, process of voice/data communication and interworking with PCs. Accordingly, smart phones may more smoothly drive applications for diagnosing home appliances. Hereinafter, although the portable terminal 100 is a smart phone, for example, the present invention is not limited thereto.

The home appliance includes a sound output unit, such as a speaker or buzzer, which outputs a sound. The sound output unit reproduces information on the operation, state, or failures of the home appliance and outputs the information in the form of a predetermined sound.

The home appliance stores product information for each of steps in which a configured operation proceeds. Here, the product information may include operation information reflecting the state of an operation currently in progress, failure information when a failure occurs, and configuration information set by a user.

For example, when the home appliance causes a failure or a malfunction during the operation, the home appliance stores product information including operation information, failure information, and configuration information. Accordingly, even when the home appliance abruptly stops operating due to, e.g., power outage, product information for the steps already done among the steps of the operation is already stored and may be used to determine the time up to which the operation has been performed and which steps are not performed yet.

A user brings the portable terminal 100 closer to a sound generating portion of the home appliance, that is, the sound output unit of the home appliance and then manipulates a selecting unit of the home appliance so that a signal sound including product information is output through the sound output unit. Accordingly, the thusly output signal sound including the product information may be input to the portable terminal 100.

The portable terminal 100 inversely extracts the product information from the received signal sound and then diagnoses the state and failures of the home appliance based on the product information. The process of diagnosing the home appliance which is performed by the portable terminal 100 will be described below in detail.

FIG. 1(b) shows another embodiment of a home appliance diagnosing system that performs diagnosis on a home appliance by a method of operating a portable terminal according to an embodiment of the present invention.

The home appliance diagnosing system 20 according to the embodiment is the same as the home appliance diagnosing system 10 according to the embodiment in that the home appliance diagnosing system 20 also diagnoses a home appliance through the portable terminal 100 but differs from the home appliance diagnosing system 10 in that the portable terminal 100 communicates with a service center 200.

More specifically, the portable terminal 100 may additively receive diagnosis data from a diagnosing server of the service center 200 or may transmit a diagnosis result of the home appliance to the diagnosing server.

The home appliance diagnosing system 20 may more specifically diagnose the home appliance using plentiful diagnosis data provided from the service center 200 and may expand database for diagnosing the home appliance since diagnosis results of the home appliance may be stored in the service center 200.

Meanwhile, the home appliance may output a signal sound including product information through a modulation scheme such as FSK (Frequency Shift Keying), ASK (Amplitude Shift Keying), or PSK (Phase Shift Keying).

Hereinafter, an example where data consisting of 0's and 1's is output through a signal sound constituted of a combination of two frequencies is described. However, the frequency of the signal sound output from the home appliance is not limited thereto and may be varied depending on the available frequency bandwidth of the sound output unit of the home appliance.

The home appliance may output a signal sound with a frequency of about 2.6 kHz corresponding to data 0 and may output a signal sound with a frequency of about 2.8 kHz corresponding to data 1. For example, since data '010' has a first bit value of 0, a second bit value of 1 and a third bit value of 0, a signal sound with a frequency of about 2.6 kHz, a signal sound with a frequency of about 2.8 kHz and a signal sound with a frequency of about 2.6kHz are output in order. Each of the signal sound with any one of 2.6 or 2.8kHz is output during a given size of unit time, respectively.

At this time, an example is described in which each bit has one symbol, a signal sound includes plurality of frequency signal, each of the frequency signal corresponds to any one of the symbol. The unit time is defined as a symbol time.

Under the conditions described above, since one symbol corresponds to the one frequency signal, a basic unit of the frequency signal constituting a signal sound output through a home appliance is considered as a symbol, for ease of description.

When a signal is unitized based on the symbol time in the portable terminal 100, a delay may occur when the frequency signals are processed in the portable terminal 100 because resources are occupied by other applications that are being driven in the portable terminal 100, and thus, the product information may not be accurately extracted. Accordingly, it is preferred to enable a precise signal sound to be output and transferred by determining the number of pulses constituting one symbol, i.e., the number of pulses included in one frequency signal output corresponding to the symbol to thus set a symbol time. For example, it may be possible to count the number of pulses by tracing the maximum amplitude of pulses included in a frequency signal input to the portable terminal 100 and to unitize a signal according to the number of the pulses.

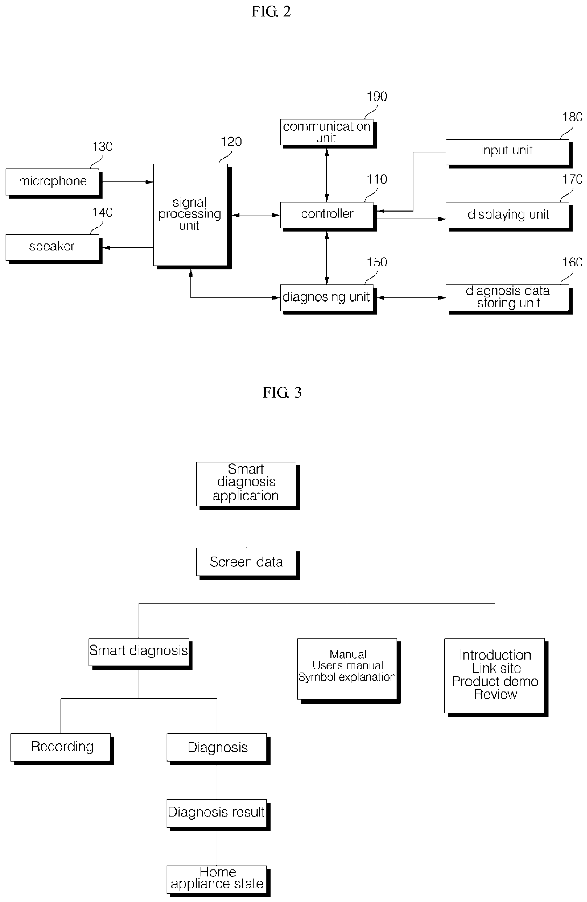

FIG. 2 is a block diagram illustrating main elements of the portable terminal shown in FIG. 1. Referring to FIG. 2, the portable terminal 100 may include a controller 110, a signal processing unit 120, a microphone 130, a speaker 140, a diagnosing unit 150, a diagnosis data storing unit 160, a display unit 170, an input unit 180, and a communication unit 190.

The microphone 130 receives a sound including product information output from a home appliance. As an example, a microphone typically prepared in the portable terminal for a calling function may be used as the microphone 130.

The speaker 140 outputs various messages to a user while performing diagnosis on the home appliance. For example, a speaker typically prepared in the portable terminal for a calling function may be used as the speaker 140.

The signal processing unit 120 extracts product information from a sound received through the microphone 130. At this time, signal conversion performed by the signal processing unit 120 is reverse conversion of signal conversion performed by the home appliance. The signal processing unit 120 may convert a signal sound, which is an analogue signal with a predetermined frequency bandwidth, into digital data.

Further, the signal processing unit 120 may extract a control signal on a per-frame basis from the converted data and may then decode the control signal thus extracting the product information. At this time, the signal processing unit 120 may detect a preamble indicating the start of data including the product information, may detect the control signal including the product information based on the detected preamble, and may decode the control signal having a designated format in a decoding scheme corresponding to a product information encoding scheme of the home appliance, thereby extracting the product information of the home appliance included in the control signal.

The diagnosing unit 150 diagnoses the operational state or failures of the home appliance by analyzing the product information extracted by the signal processing unit 120. The diagnosing unit 150 performs diagnosis on the home appliance by analyzing the product information through a diagnosis application.

The diagnosis data storing unit 160 stores information on error codes of a home appliance, whether there are errors, and diagnosis data for diagnosing cause of an error and data regarding how to solve errors depending on the cause of the errors. The diagnosis data storing unit 160 may include various recording media such as a hard disk, a flash memory, a Read Only Memory (ROM), or a Sold State Drive (SSD).

The input unit 180 includes at least one input means to enter a predetermined signal or data to the controller 110 by a user's manipulation, and such input means may include a touch screen that performs image displaying and command entering functions, a button-type/dial-type manipulation key or a keyboard. A user may drive a diagnosis application through a specific input means among the various input means provided in the input unit 180.

In particular, the input unit 180 may include a key pad, a dome switch, or a capacitive or resistive touch pad through which commands or information may be entered by the user's pushing or touching. Further, the input unit 180 may be configured as a jog wheel for rotating a key or as a manipulation type such as a jog type or a joy stick or may be configured as a finger mouse. In particular, when a touch pad has a layered structure with the display unit 170 to be described later, this structure may be referred to as a touch screen.

The display unit 170 displays a user interface image for each execution step of a diagnosis application. The display unit 170 may include, e.g., a Liquid Crystal Display (LCD) or various displays using, e.g., Light Emitting Diodes (LEDs).

Meanwhile, when the portable terminal 100 has a touch screen as the display unit 170, the touch screen may have the functions of both the display unit 170 and the input unit 180, and in such case, a selection area displayed on a user interface image displayed on the touch screen for selection of various menus may be referred to as performing the functions of the input unit 180. Accordingly, the display unit 170 and the input unit 180 do not need to be physically separated from each other, and the other components shown in FIG. 2 are merely assigned with their names for functionally discerning one component from another, and thus, the components should be prohibited from being construed as referring to separate physical devices, respectively.

The communication unit 190 allows for transmission of data between the portable terminal 100 and the service center 200. The communication unit 190 may include a mobile communication module that allows wireless signals to be transmitted/received to/from a base station, an external terminal, or a server and a wireless Internet module that allows for wireless Internet access.

As wireless Internet technologies, WLAN(Wireless Lan), Wi-Fi's, Wibro (Wireless broadband), Wimax (World Interoperability for Microwave Access), or HSDPA (High Speed Downlink Packet Access) may be adopted.

The controller 110 controls the operation of each of the components and the overall operation of the portable terminal 100. The controller 110 will be described below in greater detail together with the operation of components controlled by the controller 110.

FIG. 3 is a view illustrating a configuration of an application driven by the portable terminal shown in FIG. 2 in order to diagnose a home appliance. Referring to FIG. 3, a smart diagnosis application installed in the portable terminal 100 is provided to diagnose a home appliance. The smart diagnosis application provides a smart diagnosis menu for analyzing an operation state of the home appliance and advising a measurement corresponding thereto, a manual menu for describing how to use the smart diagnosis application, a demo menu for showing how the smart diagnosis application actually operates, and a introduce menu for providing information such as users' reviews or related websites' addresses.

When the smart diagnosis menu is selected, a signal sound including product information output from the home appliance may be recorded, the production information may be inversely extracted from the recorded signal sound, and the product information may be analyzed, thereby performing diagnosis on the home appliance. A result of the diagnosis may be output to be recognized by a user. At this time, the portable terminal may call a repair person of the service center 200 through a communication network.

When the manual menu is selected, a guide image is output which includes descriptions of icons displayed on each image and manual of the smart diagnosis application.

When the introduce menu is selected, an image may be output which displays demos, reviews, or links to related Internet websites of the smart diagnosis application.

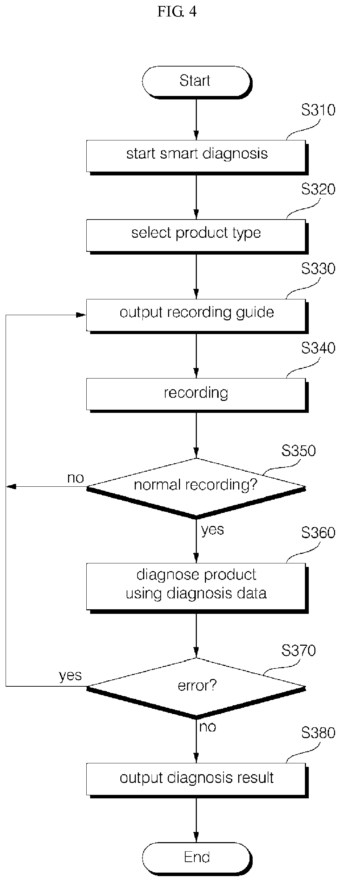

FIG. 4 is a flowchart illustrating a method of operating a portable terminal according to an embodiment of the present invention.

Referring to FIG. 4, a method of operating a portable terminal according to an embodiment of the present invention may include a step of starting diagnosis on a home appliance (S310), a step of selecting the type of a product (S320), a step of outputting a recording guide (S330), a recording step (S340), a step of determining whether the recording is normally done (S350), a product diagnosing step (S360), a step of determining a diagnosis error (S370), and a step of outputting a diagnosis result (S380).

In the step S310 of starting diagnosis on the home appliance, a diagnosis on the home appliance is started in responding to a user's selection. The diagnosis may be initiated by the user's entry of a diagnosis application driving command through the input unit 180. The controller 110 performs control to enable a user interface image for conducting diagnosis of the home appliance to be displayed through the display unit 170.

In the product type selecting step S320, the type of a product to be diagnosed is selected. At this time, the controller 110 may display a selection menu for selecting the type of a home appliance to be diagnosed through the display unit 170.

In the recording guide outputting step S330, information regarding how to output the product information as a signal sound in the home appliance selected in the product type selecting step S320 and information as to a position of the sound outputting unit of the product to which the portable terminal 100 is to be brought in order to accurately record the output signal sound are provided to a user. For this purpose, the controller 110 performs control that enables a manipulating method for outputting a signal sound including the product information from the home appliance selected in the product type selecting step S320 to be displayed through the display unit 170. At this time, an image of the home appliance, which indicates the position to which the portable terminal 100 needs to be brought, may be displayed together.

In the recording step S340, a signal sound input through the microphone 130 is recorded. The signal sound input through the microphone 130 is transmitted to the signal processing unit 120, and the signal processing unit 120 records the signal sound. While recording is in progress, the controller 110 may control the display unit 170 to display recording status of the signal sound.

In the normal recording determining step S350, whether the signal sound input through the microphone 130 is normally recorded is determined. The signal processing unit 120 may notify whether the recording is normally done or whether errors occurs to the controller 110. and the controller 110 may control the display unit 170 to display a result of the notification.

In particular, the sound pressure of a signal sound being recorded in the normal recording determining step S350 may be measured, and the controller 110 may perform control to enable recording to be stopped and to enable a recording failure message to be displayed through the display unit 170 when the measured sound pressure does not reach a predetermined value. At this time, a message may be displayed which indicates that the sound pressure is too low while requesting the portable terminal 100 to be brought closer to the home appliance, that is, a position closer to the sound outputting unit that outputs the signal sound.

The product diagnosing step S360 includes a signal processing step of extracting product information from the recorded signal sound and a diagnosing step of performing diagnosis on the home appliance based on the extracted product information.

In the signal processing step, the signal processing unit 120 extracts product information from the signal sound completely recorded in the recording step S340.

In the diagnosing step, the diagnosing unit 150 diagnoses the home appliance based on the product information extracted in the signal processing step. At this time, diagnosis data is obtained from the diagnosis data storing unit 160, and the diagnosing unit 150 analyzes the product information by utilizing the diagnosis data.

In the diagnosis error determining step S370, it is determined whether the diagnosis is accurately done in the product diagnosing step S360. Although recording has been normally performed in the recording step S340, the product information extracted from the recorded signal sound may include error data. Thus, when the diagnosis is determined not to be correctly performed due to such error data, the process returns to the recording guide outputting step S330 so that a user may retry to perform recording.

In the diagnosis result outputting step S380, a result of diagnosis on the home appliance is output. The controller 110 may control the display unit 170 to display a result of the diagnosis performed on the home appliance in the product diagnosing step S360.

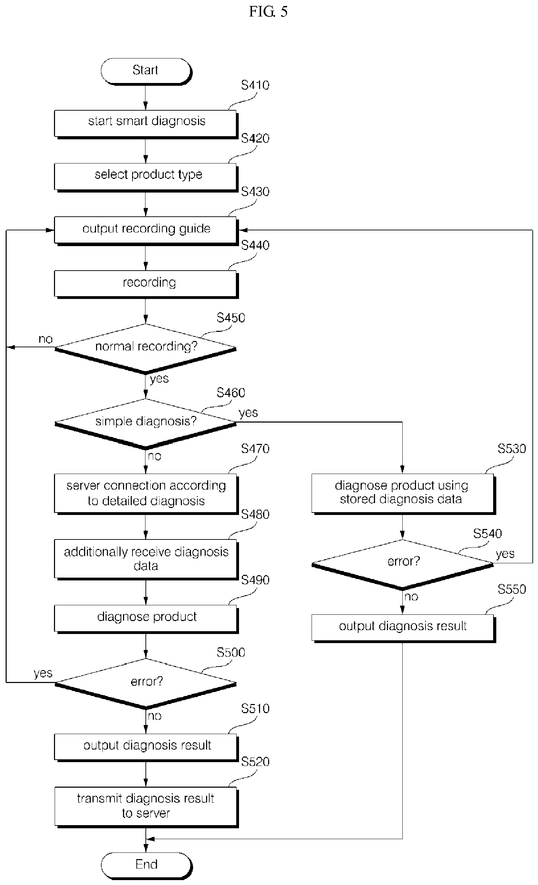

FIG. 5 is a flowchart illustrating a method of operating a portable terminal according to another embodiment of the present invention. A difference between the embodiment of a method of operating a portable terminal described above in connection with FIG. 4 and the embodiment of a method of operating a portable terminal to be described below is that diagnosis data may be additively obtained from a diagnosis server so that the home appliance may be diagnosed more specifically. There is a need for a diagnosis server storing additional diagnosis data, and such diagnosis server may be provided in the service center 200.

A home appliance diagnosing starting step S410, a product type selecting step S420, a recording guide outputting step S430, a recording step S440, a normal recording determining step S450, a diagnosis error determining step S500 and S540, and a diagnosis result outputting step S510 and S550 are substantially the same as the home appliance diagnosis starting step S310, the product type selecting step S320, the recording guide outputting step S330, the recording step S340, the normal recording determining step S350, the diagnosis error determining step S370, and the diagnosis result outputting step S380 of the embodiment, and the description thereof will be skipped.

In a simple diagnosis selecting step S460, it is selected whether to perform diagnosis on the home appliance using only the diagnosis data stored in the portable terminal 100 without receiving additional diagnosis data from the diagnosis server as in the embodiment (hereinafter, referred to as "simple diagnosis") or to perform diagnosis on the home appliance by receiving additional diagnosis data from the diagnosis server as necessary (hereinafter, referred to as "detailed diagnosis").

When a user selects the simple diagnosis in the simple diagnosis selecting step S460, a product diagnosing step S530, a diagnosis error determining step S540, and a diagnosis result outputting step S550 are performed. Such process involves performing diagnosis on the home appliance using the diagnosis data previously stored in the diagnosis data storing unit 160, and is substantially the same as the method of operating a portable terminal according to the embodiment described above.

When the simple diagnosis is not selected in the simple diagnosis selecting step S460 (that is, the detailed diagnosis is selected), a server accessing step S470, a diagnosis data receiving step S480, a product diagnosing step S490, a diagnosis error determining step S500, a diagnosis result outputting step S510, and a diagnosis result transmitting step S520 are performed.

In the server accessing step S470, the communication unit 190 of the portable terminal 100 is connected to the diagnosis server of the service center 200 to communicate with each other.

In the diagnosis data receiving step S480, diagnosis data is additively transmitted from the diagnosis server to the portable terminal 100, and based on this, the diagnosis data stored in the diagnosis data storing unit 160 is renewed. However, if the diagnosis data previously stored in the portable terminal 100 is enough to diagnose the home appliance, the diagnosis data receiving step S480 may be omitted.

The product diagnosing step S490 is substantially the same as the product diagnosing step S360 of the embodiment except that diagnosis is performed using diagnosis data additively received in the diagnosis data receiving step S480.

In the diagnosis result transmitting step S520, a result of the diagnosis performed in the product diagnosing step S490 is transmitted to the diagnosis server. The diagnosis result may vary depending on various factors such as operation environment, operation frequency, and operation settings that tend to be different for each user, and diagnosis results are transmitted from each user to the diagnosis server and are accumulated in the diagnosis server, so that the diagnosis data is updated to reflect various factors, which allow for more correct diagnosis when the detailed diagnosis is subsequently performed.

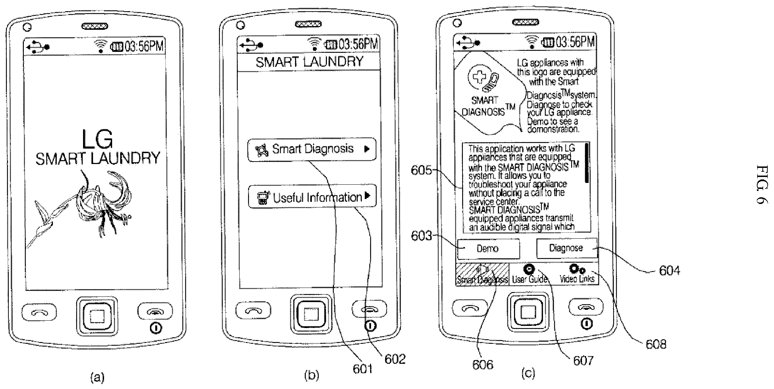

FIGS. 6 to 11 illustrate images that are displayed through the display unit shown in FIG. 2 when performing diagnosis on a home appliance. Hereinafter, description will be given with reference to FIGS. 6 to 10.

FIG. 6(a) shows an intro image displayed when a diagnosis application installed in the portable terminal 100 is executed. A manufacturer (LG) and a logo (smart laundry) are put in place. While the intro image is being displayed, the diagnosis application is loaded. While the diagnosis application is fully loaded, a main image is automatically activated.

FIG. 6(b) illustrates an example of the main image that includes a diagnosis mode selection menu 601 and an additional information displaying menu 602.

The selection of the diagnosis mode selection menu 601 corresponds to the home appliance diagnosis starting step of FIG. 4 or FIG. 5. If the diagnosis mode selection menu 601 is selected, an application information displaying image may be displayed for providing information on the diagnosis application.

FIG. 6(c) shows an example of the application information displaying image. The application information displaying image may include a diagnosis product information display area 605 that displays a brief description of the home appliances to be diagnosed using the diagnosis application, a demo menu 603, and a diagnosis performing menu 604.

If the demo menu 603 is selected, an image (not shown) providing a process of demonstrating diagnosis on a home appliance using the diagnosis application may be displayed.

If the diagnosis performing menu 604 is selected, steps S320 to S380 of FIG. 4 or steps S420 to S550 of FIG. 5 are performed, and an image provided at each step is displayed through the display unit 170.

Meanwhile, after the diagnosis mode selection menu 601 is selected, predetermined menu areas 606, 607, and 608 may be displayed on a lower portion of the image displayed by the display unit 170. The menu areas may include a diagnosis menu 606, a user guiding menu 607, and a video link menu 608. The menu 606 corresponding to the current progressing state is displayed to be distinguished from the other menus 607 and 608, and depending on a menu selected by a user, an image associated with the corresponding menu is activated.

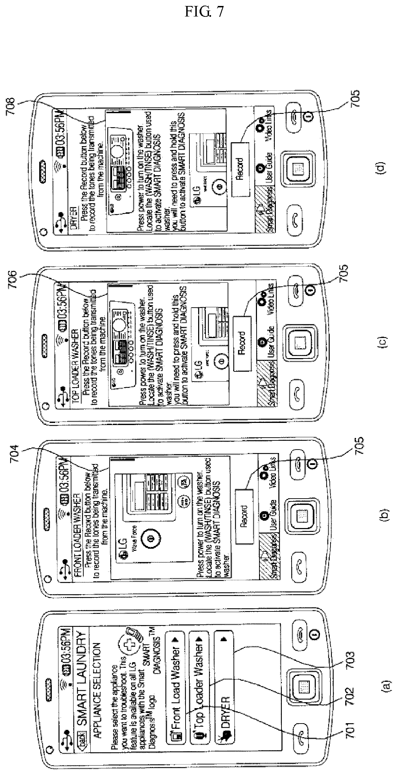

FIG. 7(a) shows an example of an image in which a targeted home appliance for diagnosis is selected which may be displayed when the diagnosis performing menu 604 is selected. On the screen of the display unit 170 are displayed predetermined menus through which the type of home appliances to be diagnosable through the diagnosis application may be selected, that is, diagnosis target selection menus 701 to 703 provided for a user to be able to select the type of a home appliance desired to be diagnosed.

In the case of an application performing diagnosis on a laundry treating apparatus, the diagnosis target selection menu may include an area 701 for selecting a front load washer generally referred to as a drum-type washer in which laundry is loaded through a laundry inserting hole formed at the front side, an area 702 for selecting a top loader washer in which laundry is loaded through a laundry inserting hole formed at the top side, and an area 703 for selecting a dryer.

Each of the images shown in FIGS. 7(b), (c), and (d) includes manual displaying areas 704, 706, and 708 for displaying a manipulating method for outputting a signal sound including product information from a targeted home appliance for diagnosis and a recording menu 705 which enables a signal sound input through the microphone 130 to be recorded when selected.

In the image shown in FIG. 7(a), if a user selects any one of the diagnosis target selection menus 701, 702, and 703, a description for guiding a manipulating method for outputting a signal sound including product information from the selected home appliance is displayed on the manual displaying areas 704, 706, and 708.

More specifically, FIG. 7(b) shows an image to be displayed when the front load washer selecting area 701 is selected and illustrates a manipulating method for outputting a signal sound including product information from the front load washer. Specifically, the washer powers on and the portable terminal 100 is brought close to the washing/rinsing button of the washer. Then, the washing/rinsing button is left pressed for a predetermined time so as to output the signal sound including the product information, and the recording menu 705 is instructed to be selected for recording the signal sound output from the washer. The instruction is directed to the front load washer that outputs the signal sound including the product information through a gap where the washing/rinsing button is installed.

FIG. 7(c) shows an image displayed when the top load washer selecting area 702 is selected and illustrates a manipulating method for outputting a signal sound including product information from the top load washer. Specifically, the washer powers on and the portable terminal 100 is brought close to the washing/rinsing button of the washer. Then, the washing/rinsing button is left pressed for a predetermined time so as to output the signal sound including the product information, and the recording menu 705 is instructed to be selected for recording the signal sound output from the washer. The instruction is directed to the top load washer that outputs the signal sound including the product information through a gap where the washing/rinsing button is installed.

FIG. 7(d) shows an image displayed when the dryer selecting area 703 is selected and illustrates a manipulating method for outputting a signal sound including product information from the dryer. Specifically, the dryer powers on and the portable terminal 100 is brought close to the washing/rinsing button (for example, when the washer comes up with drying functions). Then, the washing/rinsing button is left pressed for a predetermined time so as to output the signal sound including the product information, and the recording menu 705 is instructed to be selected for recording the signal sound output from the dryer. Such instruction is related to when the signal sound including the product information is output through a gap where the washing/rinsing button is installed.

It may be particularly noted that an image for the position of a specific button for outputting the signal sound including product information from a corresponding home appliance is put on each of the manipulating method displaying areas 704, 706, and 708 of FIGS. 7(b), (c), and (d) so that a user may be intuitively aware of a manipulating method through the image.

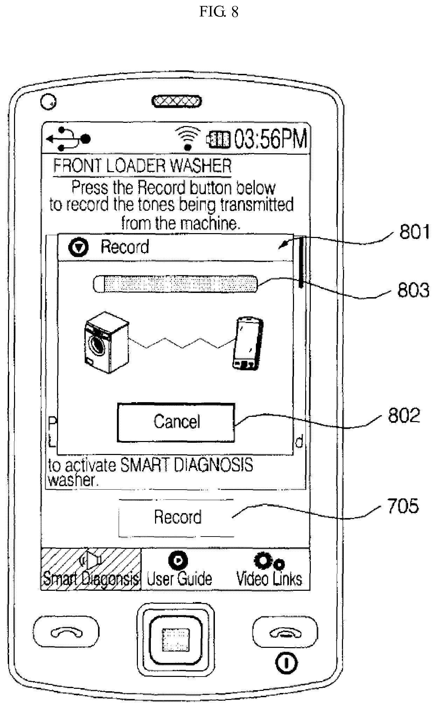

Meanwhile, FIG. 8 shows an example of an image activated when the recording menu 705 is selected, in which a recording progress displaying area 801 shows up on the image in the form of a pop-up window. On the recording progress displaying area 801 may be displayed a bar-shaped icon 803 whose length increases as recording is underway and a recording canceling menu 802. If a signal sound input through the microphone 130 departs from a predetermined frequency range which may be processed by the signal processing unit 120 or recording cannot be normally done due to, e.g., failure to reaching a predetermined sound pressure range, the controller 110 may perform control to enable a message to be displayed through the display unit 170 to notify that recording has failed.

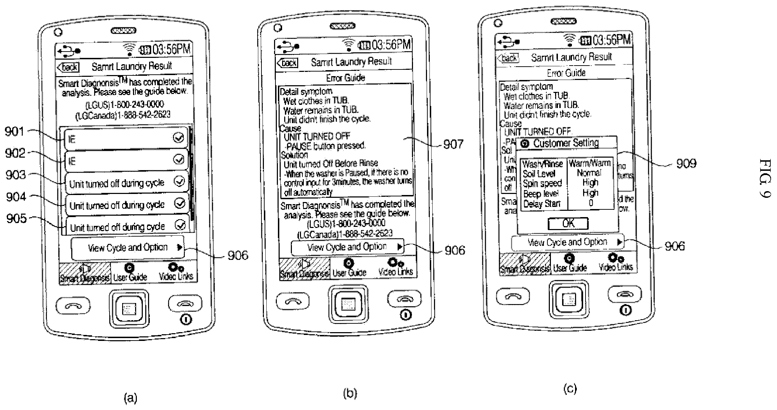

FIG. 9 shows images in which recording has been successfully done and results of diagnosis performed on a home appliance are displayed.

FIG. 9(a) shows an example of a product information displaying image in which product information of the home appliance is displayed. The product information output from the home appliance in the form of a signal sound includes an error code generated from the home appliance, operation information reflecting the operating state of the home appliance, and configuration information set by a user.

The product information displaying image displays product information extracted from a signal sound in the diagnosing unit 150, with the product information classification. Specifically, the product information displaying image may include error code displaying areas 901 and 902 and operation information display areas 903, 904, and 905.

Further, a configuration information displaying menu 906 may be displayed on the product information displaying image, and when the configuration information displaying menu 906 is selected, configuration information is displayed through the screen.

FIG. 9(b) shows an example of an image activated when the error code displaying areas 901 and 902 or operation information display areas 903, 904, and 905 are selected. Such image may include a diagnosis result displaying area 907 and a configuration information displaying menu 906.

The diagnosis result displaying area 907 may display detailed symptoms, cause, and solutions of a home appliance based on results of the diagnosis performed by the diagnosing unit 150.

Meanwhile, the same error code IE is displayed on the error code displaying areas 901 and 902 shown in FIG. 9(a). However, although the same error code is generated from the home appliance, it may be involved with various different causes. Accordingly, different detailed descriptions may be displayed through the diagnosis result displaying area 907 that is activated when each error code displaying area 901 and 902 is selected.

Likewise, although the same operation information is displayed on the operation information display areas 903, 904, and 905 shown in FIG. 9(a), different detailed information for the corresponding operation information may be displayed on each diagnosis result displaying area 907 that is activated when each operation information display area 903, 904, and 905 is selected.

FIG. 9(c) shows an example of a configuration information display area (909) activated when a configuration information displaying menu 906 is selected. The configuration information display area 909 may be configured in the form of a pop-up window. On the configuration information display area 909 may be displayed information for a cycle done just before diagnosis is performed, values sensed by various sensors while the home appliance is in operation, and configuration information set by a user.

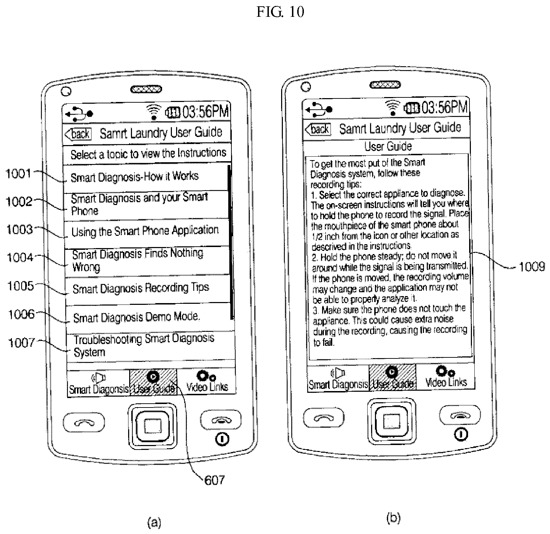

FIG. 10 shows an example of a user guiding displaying image displayed when a user guiding menu 607 is selected.

Referring to FIG. 10(a), the user guiding displaying image may include various selecting areas 1001 to 1007.

When the selecting area 1001 is selected, an image (not shown) displaying a description on a principle for diagnosing the home appliance is activated.

When the selecting area 1002 is selected, an image (not shown) displaying a description on relevancy between the diagnosis of the home appliance and a portable terminal (e.g., smart phone) is activated.

When the selecting area 1003 is selected, an image (1009 in FIG. 10(b)) displaying a method of using a diagnosis application is activated.

When the selecting area 1004 is selected, an image (not shown) displaying a description on when a diagnosis result shows no failure occurs to the home appliance is activated.

When the selecting area 1005 is selected, an image (not shown) displaying additional information related to recording a signal sound including product information is activated.

When the selecting area 1006 is selected, an image (not shown) displaying a description on a method of making use of a diagnosis demonstration (refer to 603) is activated.

When the selecting area 1007 is selected, an image (not shown) displaying a description on a method of solving problems that may occur when the diagnosing system is in operation is activated.

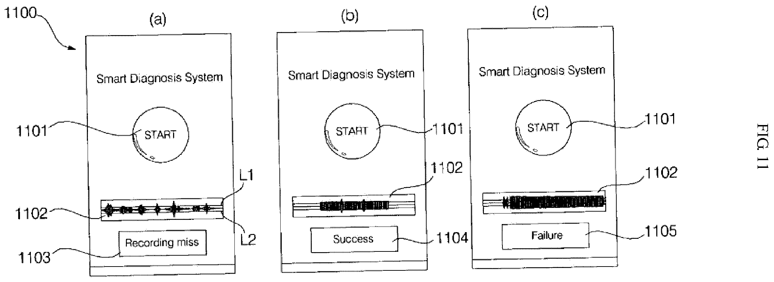

FIG. 11 shows images displayed when recording a signal sound including product information output from a home appliance by a portable terminal according to an embodiment of the present invention.

Referring to FIGS. 4 and 5, embodiments of a method of operating a terminal according to an embodiment of the present invention include a recording guide outputting step S330 or S430, a recording step S340 or S440, a normal recording determining step S350 or S45, and a diagnosis error determining step S370, S500, or S540.

FIG. 11 shows images displayed on the display unit 170 as each of the steps proceeds. On the images shown in FIG. 11 is displayed a recording menu 1101 different in form from the recording menu 705 shown in FIG. 7 but performing substantially the same function as the recording menu 705.

If the recording menu 1101 is selected, the recording step S340 or S440 is performed. At this time, a recording progress state is displayed on the screen of the display unit 170. In particular, a change in sound pressure of a signal sound including product information which is being received through the microphone 130 is displayed on the screen of the display unit 170.

While recording is on, the controller 110 performs control to enable the sound pressure of a signal sound being currently recorded through the sound pressure displaying area 1102 to be displayed on the screen of the display unit 170.

On the sound pressure displaying area 1102 may be displayed a waveform vibrating up and down as times elapse. The amplitude of the waveform being larger means the sound pressure is higher. On the sound pressure displaying area 1102 may show up two (upper and lower) sound pressure reference lines L1 and L2. The sound pressure reference lines L1 and L2 indicate proper levels of the sound pressure necessary for diagnosis. A user may leave the sound pressure at a proper level by comparing the waveform displayed on the sound pressure displaying area 1102 with the sound pressure reference lines and by adjusting the distance between the portable terminal 100 and the home appliance.

Meanwhile, when the sound pressure of a sound entered through the microphone 130 fails to reach a predetermined level as shown in FIG. 11(a), a message 1103 may be displayed through the display unit 170 to indicate that recording has been failed. Only when a signal sound including product information received through the microphone 130 maintains a predetermined level or higher, the signal sound processing and product information extracting may be accurately conducted by the signal processing unit 120 and the diagnosing unit 150. Accordingly, when the signal sound including the product information does not have a predetermined level of sound pressure may be also known to a user, thereby inducing the user to retry to perform recording.

When the recording of a signal sound is done successfully as shown in FIG. 11(b), a message may be displayed to indicate that recording has been succeeded. The recording success message may be merely the one indicating that the signal sound received through the microphone 130 has been completely recorded. Further, the recording success message may further indicate that decoding is also complete so that product information extracting and diagnosing have been finished. In particular, the time taken from when recording is started to when diagnosis is done is very short and what a user cares about is whether diagnosis on a home appliance has been successfully done while it is not a big deal to notify only the fact that recording has been successful with the recording separated from the diagnosing process. Accordingly, it is preferable to display the diagnosis success message 1104 after diagnosis is complete.

FIG. 11(c) shows an image displayed when signal sound recording is successfully done but diagnosis on a home appliance is not normally done. That is, FIG. 11(c) is directed when a signal sound with a proper sound pressure necessary for product information conversion is received through the microphone 130 and recording is normally done, but a distortion occurs while the signal sound is being recorded and causes an error in the product information extracted from the signal sound. In such case, the product information converted by the signal processing unit 120 departs from a designated format, and thus, the diagnosing unit 150 cannot normally perform diagnosis. Thus, the controller 110 performs control to enable a diagnosis failure message 1105 to be displayed through the display unit 170, thus inducing a user to manipulate the home appliance again to output a signal sound including the product information and to retry to record the output signal sound.

Meanwhile, although each image shown in FIG. 11 does not represent a manipulating method of outputting a signal sound including product information from a home appliance, a guide for the manipulating method may be displayed on the same image together with the recording menu 1101 as shown in FIG. 7(b) to (d).

It may be understood by one of ordinary skill in the art that many other modifications and variations may be made to the present invention without departing from the essential features of the invention. Accordingly, the embodiments described thus far should be construed as being exemplary but not as limiting.

## Claims

1. A method of operating a portable terminal (100), the method comprising:
starting (S310), upon receipt of a user input through an input unit (180), diagnosis of a home appliance;
displaying (S320) a selection menu for selecting the type of the home appliance (1,2,3) for diagnosis through a display unit (170);
displaying (S330) how to manipulate the home appliance selected through the selection menu to output a sound signal including product information of the home appliance selected through the selection menu with an image showing a position on the home appliance selected through the selection menu, to which the portable terminal (100) is to be brought;
displaying a recording menu through the display unit;
recording (S340, S440) a signal sound output by the home appliance and including product information and received through a microphone (130) according to a selection of the recording menu;
extracting (S360) product information of the home appliance from the recorded signal sound;
performing diagnosis (S360, S490, S530) based on extracted product information; and
displaying (S380, S510, S550) a result of performing the diagnosis through the display unit (170).

2. The method of claim 1, wherein the manipulating method for outputting the signal sound and the recording menu are displayed on the same screen.

3. The method of claim 1, further comprising displaying a recording progress state of the signal sound through the display unit (170).

4. The method of claim 3, wherein displaying of the recording progress state comprises displaying a change in a sound pressure of the signal sound that is being recorded.

5. The method of claim 4, wherein the signal sound is displayed as a waveform in which an amplitude thereof is proportional to a sound pressure thereof.

6. The method of claim 5, further comprising displaying whether or not recording the signal sound is normally completed through the display unit.

7. The method of claim 6, wherein displaying of whether or not the recording the signal sound is normally completed comprises displaying a recording failure message (1103) when the sound pressure of the signal sound does not reach a predetermined level.

8. The method of claim 1, further displaying a certain diagnosis failure message (1105) through the display unit when the performing of diagnosis fails.

9. The method of claim 1, wherein the displaying of the result of performing the diagnosis comprises displaying an operation information display area (903, 904, 905) in which operation information comprised in product information is classified for each item of operation information.

10. The method of claim 9, wherein the displaying of the result of performing the diagnosis further comprises:
selecting one item from the operation information display area; and
displaying detailed information corresponding to the selected item.

11. The method of claim 10, wherein displaying of the detailed information comprises displaying at least one of an unusual symptom of a home appliance (1,2,3), a cause of the unusual symptom, and a solution of the unusual symptom, based on the result of performing the diagnosis.

12. The method of claim 1, wherein the performing of the diagnosis is performed based on diagnosis data stored in a diagnosis data storing unit (160).

13. The method of claim 12, further comprising:
receiving the diagnosis data through a communication unit (190); and
updating the diagnosis data stored in the diagnosis data storing unit (160) based on the received diagnosis data.

## Patentansprüche

1. Verfahren zum Betreiben eines tragbaren Endgeräts (100), wobei das Verfahren umfasst:
Starten (S310) der Diagnose eines Haushaltsgeräts nach Empfang einer Benutzereingabe über eine Eingabeeinheit (180);
Anzeigen (S320) eines Auswahlmenüs zum Auswählen der Art des Haushaltsgeräts (1, 2, 3) für die Diagnose über eine Anzeigeeinheit (170);
Anzeigen (S330), wie das über das Auswahlmenü ausgewählte Haushaltsgerät betätigt werden kann, um ein Tonsignal mit Produktinformationen des über das Auswahlmenü ausgewählten Haushaltsgerätes mit einem Bild auszugeben, das eine Position auf dem über das Auswahlmenü ausgewählte Haushaltsgerät zeigt, zu der das tragbare Endgerät (100) zu bringen ist;
Anzeigen eines Aufzeichnungsmenüs über die Anzeigeeinheit;
Aufzeichnen (S340, S440) eines durch das Haushaltsgerät ausgegebenen und Produktinformationen enthaltenden Signaltons, der durch ein Mikrofon (130) gemäß einer Auswahl des Aufzeichnungsmenüs empfangen wird;
Extrahieren (S360) von Produktinformationen des Haushaltsgeräts aus dem aufgezeichneten Signalton;
Durchführen von Diagnosen (S360, S490, S530) basierend auf extrahierten Produktinformationen; und
Anzeigen (S380, S510, S550) eines Ergebnisses des Durchführens der Diagnose über die Anzeigeeinheit (170).

2. Verfahren nach Anspruch 1, wobei das Betätigungsverfahren zum Ausgeben des Signaltons und das Aufzeichnungsmenü auf demselben Bildschirm angezeigt werden.

3. Verfahren nach Anspruch 1, ferner umfassend das Anzeigen eines Aufzeichnungsfortschrittszustands des Signaltons durch die Anzeigeeinheit (170).

4. Verfahren nach Anspruch 3, wobei das Anzeigen des Aufzeichnungsfortschrittszustands das Anzeigen einer Änderung des Schalldrucks des aufzuzeichnenden Signaltons umfasst.

5. Verfahren nach Anspruch 4, wobei der Signalton als eine Wellenform angezeigt wird, bei der eine Amplitude proportional zu einem Schalldruck ist.

6. Verfahren nach Anspruch 5, ferner umfassend das Anzeigen, ob die Aufzeichnung des Signaltons normal durch die Anzeigeeinheit abgeschlossen ist oder nicht.

7. Verfahren nach Anspruch 6, wobei das Anzeigen, ob die Aufzeichnung des Signaltons normal abgeschlossen ist oder nicht, das Anzeigen einer Aufzeichnungsfehlermeldung (1103) umfasst, wenn der Schalldruck des Signaltons einen vorbestimmten Pegel nicht erreicht.

8. Verfahren nach Anspruch 1, ferner das Anzeigen einer bestimmten Diagnosefehlermeldung (1105) über die Anzeigeeinheit, wenn das Durchführen der Diagnose fehlschlägt.

9. Verfahren nach Anspruch 1, wobei das Anzeigen des Ergebnisses des Durchführens der Diagnose das Anzeigen eines Betriebsinformationsanzeigebereichs (903, 904, 905) umfasst, wobei die in den Produktinformationen enthaltenen Betriebsinformationen für jedes Element der Betriebsinformationen klassifiziert sind.

10. Verfahren nach Anspruch 9, wobei das Anzeigen des Ergebnisses des Durchführens der Diagnose ferner umfasst:
Auswählen eines Elements aus dem Betriebsinformationsanzeigebereich; und
Anzeigen detaillierter Informationen entsprechend dem ausgewählten Element.

11. Verfahren nach Anspruch 10, wobei das Anzeigen der detaillierten Informationen basierend auf dem Ergebnis des Durchführens der Diagnose das Anzeigen mindestens eines aus einem ungewöhnlichen Symptom eines Haushaltsgeräts (1, 2, 3), einer Ursache des ungewöhnlichen Symptoms und einer Lösung des ungewöhnlichen Symptoms umfasst.

12. Verfahren nach Anspruch 1, wobei das Durchführen der Diagnose basierend auf Diagnosedaten, die in einer Diagnosedatenspeichereinheit (160) gespeichert sind, durchgeführt wird.

13. Verfahren nach Anspruch 12, ferner umfassend:
Empfangen der Diagnosedaten über eine Kommunikationseinheit (190); und
Aktualisieren der in der Diagnosedatenspeichereinheit (160) gespeicherten Diagnosedaten basierend auf den empfangenen Diagnosedaten.

## Revendications

1. Procédé de fonctionnement d'un terminal portable (100), le procédé comprenant :
le démarrage (S310), lors de la réception d'une entrée utilisateur via une unité d'entrée (180), d'un diagnostic d'un appareil domestique ;
l'affichage (S320) d'un menu de sélection permettant la sélection du type d'appareil domestique (1, 2, 3) à diagnostiquer, via une unité d'affichage (170) ;
l'affichage (S330) de comment manipuler l'appareil domestique sélectionné via le menu de sélection pour émettre un signal sonore incluant des informations de produit concernant l'appareil domestique sélectionné via le menu de sélection avec une image montrant une position, sur l'appareil domestique sélectionné via le menu de sélection, vers laquelle le terminal portable (100) doit être amené ;
l'affichage d'une mesure d'enregistrement via l'unité d'affichage ;
l'enregistrement (S340, S440) d'un signal sonore émis par l'appareil domestique, incluant des informations de produit et reçu via un microphone (130), selon une sélection du menu d'enregistrement ;
l'extraction (S360) d'informations de produit concernant l'appareil domestique depuis le signal sonore enregistré ;
l'exécution d'un diagnostic (S360, S490, S530) en fonction d'informations de produit extraites ; et
l'affichage (S380, S510, S550) d'un résultat d'exécution du diagnostic via l'unité d'affichage (170).

2. Procédé selon la revendication 1, dans lequel le procédé de manipulation permettant d'émettre le signal sonore et le menu d'enregistrement sont affichés sur le même écran.

3. Procédé selon la revendication 1, comprenant en outre l'affichage d'un état d'avancement d'enregistrement du signal sonore via l'unité d'affichage (170) .

4. Procédé selon la revendication 3, dans lequel l'affichage de l'état d'avancement d'enregistrement comprend l'affichage d'un changement de pression acoustique du signal sonore qui est en cours d'enregistrement.

5. Procédé selon la revendication 4, dans lequel le signal sonore est affiché sous la forme d'une forme d'onde dont l'amplitude est proportionnelle à la pression acoustique.

6. Procédé selon la revendication 5, comprenant en outre l'affichage du fait que l'enregistrement du signal sonore est normalement terminé ou non via l'unité d'affichage.

7. Procédé selon la revendication 6, dans lequel l'affichage du fait que l'enregistrement du signal sonore est normalement terminé ou non comprend l'affichage d'un message d'échec d'enregistrement (1103) lorsque la pression acoustique du signal sonore n'atteint pas un niveau prédéterminé.

8. Procédé selon la revendication 1, affichant en outre un certain message d'échec de diagnostic (1105) via l'unité d'affichage lorsque l'exécution du diagnostic échoue.

9. Procédé selon la revendication 1, dans lequel l'affichage du résultat d'exécution du diagnostic comprend l'affichage d'une zone d'affichage d'informations de fonctionnement (903, 904, 905) dans laquelle les informations de fonctionnement comprises dans les informations de produit sont classifiées pour chaque élément d'information de fonctionnement.

10. Procédé selon la revendication 9, dans lequel l'affichage du résultat d'exécution du diagnostic comprend en outre :
la sélection d'un élément à partir de la zone d'affichage d'informations de fonctionnement ; et
l'affichage d'informations détaillées correspondant à l'élément sélectionné.

11. Procédé selon la revendication 10, dans lequel l'affichage des informations détaillées comprend l'affichage d'au moins l'un d'un symptôme inhabituel d'un appareil domestique (1, 2, 3), d'une cause du symptôme inhabituel, et d'une solution du symptôme inhabituel, en fonction du résultat d'exécution du diagnostic.

12. Procédé selon la revendication 1, dans lequel l'exécution du diagnostic est effectuée en fonction de données de diagnostic stockées dans une unité de stockage de données de diagnostic (160).

13. Procédé selon la revendication 12, comprenant en outre :
la réception des données de diagnostic via une unité de communication (190) ; et
la mise à jour des donnée de diagnostic stockées dans l'unité de stockage de données de diagnostic (160) en fonction des données de diagnostic reçues.
